# EUROPEAN PATENT SPECIFICATION

(11) **EP 4 394 079 B1**
(45) Date of publication and mention of the grant of the patent: **04.02.2026**
(21) Application number: 23806984.3
(22) Date of filing: 17.05.2023
(51) Int. Cl.: C23C 16/455, C23C 16/50, C23C 16/40, C23C 16/34, C23C 16/52, H01L 21/316, C23C 16/44, C23C 16/54, H01J 37/32, H01L 21/02, H01L 21/67, H10F 71/00

(54) **SUBSTRATE TREATING APPARATUS AND METHOD**
VORRICHTUNG UND VERFAHREN ZUR SUBSTRATBEHANDLUNG
APPAREIL ET PROCÉDÉ DE TRAITEMENT DE SUBSTRAT

(30) Priority: 19.05.2022 CN 202210547272
(43) Date of publication of application: 03.07.2024
(73) Proprietor: Jiangsu Leadmicro Nano-Technology Co., Ltd., Wuxi, Jiangsu 214028 (CN)
(72) Inventor: WU, Xinyuan, Wuxi, Jiangsu 214028 (CN); LIAO, Baochen, Wuxi, Jiangsu 214028 (CN); LI, Xiang, Singapore 575745 (SG); LI, Wei Min, 02260 Espoo (FI); ZHANG, Peng, Wuxi, Jiangsu 214028 (CN); WANG, Yunsong, Wuxi, Jiangsu 214028 (CN)
(74) Representative: Bayramoglu et al.
(86) International application number: PCT/CN2023/094772
(87) International publication number: WO 2023/222033

(56) References cited:
- CN-A- 1 735 709
- CN-A- 107 119 264
- CN-A- 107 868 944
- CN-A- 109 423 695
- CN-A- 111 304 633
- CN-A- 113 416 945
- CN-A- 114 959 649
- CN-U- 207 933 525
- JP-A- 2000 144 369
- JP-A- 2015 046 588
- KR-A- 20040 034 245
- US-A1- 2011 139 272

## Description

### FIELD OF THE APPLICATION

The present application relates to the technical field of semiconductor processes, and in particular to a substrate treating apparatus and a method thereof.

### BACKGROUND

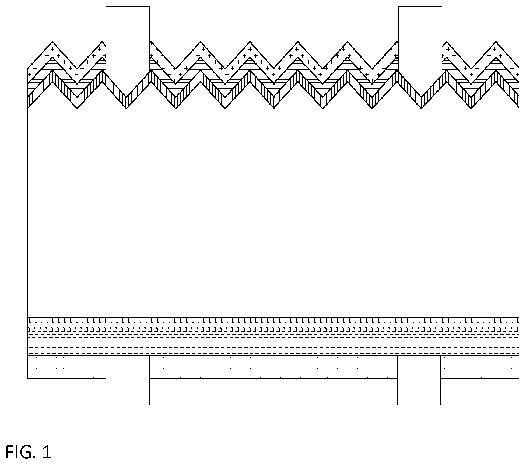

An existing tubular plasma enhanced chemical vapor deposition (PECVD) apparatus utilizes an ion enhanced technology to carry out deposition of various film layers of a tunnel oxide passivated contact (TOPCon) cell, as shown in FIG. 1, comprising a frontside laminate of aluminum oxide and silicon nitride and a backside laminate of silicon oxide, polysilicon and silicon nitride. Wherein the aluminum oxide plays a vital role in passivating a frontside boron diffusion emitter. For an aluminum oxide process of industrial mass production, an existing process for tubular equipment is mainly based on an ion enhanced process, however, a PECVD technology can not guarantee shape-retention of a thin film on front texturing morphology, and aluminum oxide deposition has a problem of nonuniformity. Meanwhile, a plasma technology may also bring a plurality of bombardment damages to a passivated surface, causing it impossible to achieve a best passivation effect. Therefore, a substrate treating apparatus and a method thereof is required to improve the problems stated above.

CN 207933525U discloses a vacuum reaction device and its reaction chamber, designed for both plasma-enhanced atomic layer deposition (PEALD) and plasma-enhanced chemical vapor deposition (PECVD). The device features a reaction chamber with an external heater and an internal conductive carrier insulated from other components. The carrier consists of at least one set of parallel plates, with adjacent plates connected to opposite poles of a plasma power source. The chamber includes gas inlets and outlets connected to a vacuum pump and gas sources, respectively. The gas sources can be reaction gases, chemical vapors, or carrier gases, with valves controlling their flow. For PEALD, the process involves cycles of chemical vapor pulsing, carrier gas purging, plasma activation, and further purging. For PECVD, chemical vapors and reaction gases are continuously introduced with sustained plasma generation.

KR 20040034245A discloses an ALD film deposition apparatus, including: a reaction chamber for accommodating at least one or more substrates; a first reaction gas line connected to the reaction chamber; a second reaction gas line connected to the reaction chamber; a third reaction gas line connected to the reaction chamber; an exhaust line for discharging the gas in the reaction chamber; a first reaction gas supply section for supplying a first reaction gas to the first reaction gas line or bypassing it to the exhaust line; a first purge gas supply unit for supplying a purge gas to the first reaction gas line or bypassing it to the exhaust line; a second reaction gas supply section for supplying a second reaction gas to the second reaction gas line or bypassing it to the exhaust line; and a third reaction gas supply section for supplying a third reaction gas to the third reaction gas line or bypassing it to the exhaust line.

### BRIEF SUMMARY OF THE APPLICATION

The present application aims to providing a substrate treating apparatus and a method thereof, performing a thermal atomic layer deposition onto the substrate on a tubular PECVD equipment platform, combining deposition processes of aluminum oxide and silicon nitride into one apparatus.

Specifically the present application provides a substrate treating apparatus and a substrate treatment method as presented in the appended claims. The appended claims define the invention, i.e. the claimed embodiments of the application.

A beneficial effect of the substrate treating apparatus in the present application is that: by transmitting the chemical source and the oxidant uniformly to the apparatus cavity through the plurality of first pipelines and the plurality of second pipelines respectively, a problem of uniformity in depositing the aluminum oxide is solved; the first fluid valves are configured to control the source bottle communicate with the first pipelines; the second fluid valves are configured to control the oxygen source communicate with the second pipelines. A process condition for performing the thermal atomic layer deposition onto the substrate on the tubular PECVD equipment platform is achieved, while shape-retention of a thin film on texturing morphology of a substrate surface is improved by depositing the thermal atomic layer, and meanwhile, damaging a passivated surface is avoided, thereby being beneficial for achieving a best passivation effect.

In addition, by arranging the pipelines, during a whole ALD process period, gas introduced into the cavity is injected into a vacuum environment through a door end of the cavity before flowing out through an opposite end, wherein a downstream of a gas outflow end has a pump with an inner part entering the cavity arranged, having a gas flow stable, thus making a flow field of the process gas a stable laminar flow, and the process controllable, therefore being able to improve quality of the film layer, further improving quality of a product.

By setting the first reaction step and the second reaction step, the thermal ALD process is realized on the tubular platform for a first time, thus forming a first deposition layer in the apparatus cavity in a pulse mode, such as aluminum oxide, silicon oxide, gallium oxide, titanium oxide or a plurality of other oxides; before further forming a second deposition layer different from the first deposition layer in the same apparatus cavity in a non-pulse mode, such as silicon nitride, in such a way, it is able to avoid a defect in the prior art caused by a direct plasma bombardment onto a surface of a silicon substrate. The present application achieves the thermal ALD process on the tubular platform for a first time, which is relatively simpler comparing to a traditional PEALD process, and it is able to perform a process adjustment by controlling a temperature, introduction flow, introduction time and concentration of the oxygen source and a TMA source only. In addition, by setting of the pipelines, selectivity of different oxygen sources is achieved, while ensuring a flow of a gas entering the cavity unchanged, when the gas is introduced in, thereby ensuring stability of a process.

### BRIEF DESCRIPTION OF THE DRAWINGS

FIG. 1 illustrates a schematic diagram on a deposition structure of various film layers of a TOPCon cell in the prior art;
FIG. 2 illustrates a schematic structural diagram on a substrate treating apparatus according to an embodiment of the present application;
FIG. 3 illustrates a schematic structural diagram on a first apparatus cavity according to an embodiment of the present application;
FIG. 4 illustrates a side view of a second apparatus cavity according to an embodiment of the present application;
FIG. 5 illustrates a schematic structural diagram on another substrate treating apparatus according to an embodiment of the present application;
FIG. 6 illustrates a flow diagram on a substrate treating method according to an embodiment of the present application;
FIG. 7 illustrates a schematic diagram on a region division to the substrate according to the present application;
FIG. 8 illustrates a box diagram on a minority carrier lifetime of a substrate according to an embodiment of the present application;
FIG. 9 illustrates a box diagram on an implied open circuit voltage of a substrate according to an embodiment of the present application;
wherein: 201-apparatus cavity; 202-carrier gas source; 203-ozone generator; 204-source bottle; 205-first pipeline; 206-second pipeline; 207-ozone destructor; 208-vacuum pump; 209-exhaust gas treater; 210-first fluid valve; 211-second fluid valve; 212-oxygen source; 213-nitrogen source; 214-third pipeline; 215-fourth pipeline; 216-heater; 220-gas channel; 221-first gas channel; 222-second gas channel; 230-furnace mouth flange; 240-oxygen source bottle; 301-purging nitrogen source; 302-silane source; 303-electrode.

### DETAILED DESCRIPTION OF EMBODIMENTS

In order to make the purpose, technical solution and advantages of the present application clearer and more explicit, further detailed descriptions of the present application are stated here, referencing to the attached drawings and some embodiments of the present application.

Unless otherwise defined, technical or scientific terms used herein should have the meanings usually understood by those of ordinary skills in the art to which the present application belongs. As used herein, the terms "comprise" and the like are intended to mean that an element or item appearing before the term encompasses elements or items appearing after the term and the equivalents thereof, instead of excluding other elements or items.

FIG. 1 illustrates a schematic diagram on a deposition structure of various film layers of a TOPCon cell in the prior art.

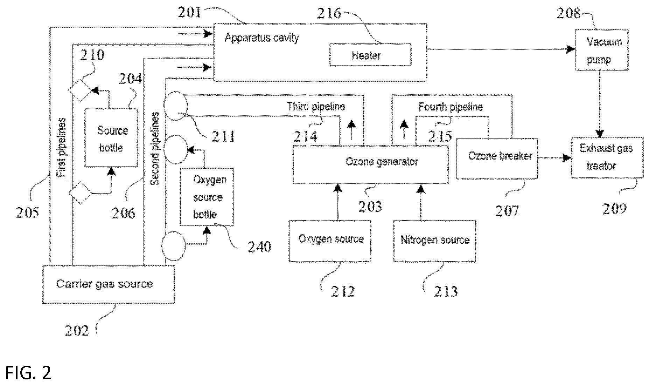

FIG. 2 illustrates a schematic structural diagram of a substrate treating apparatus according to an embodiment of the present application.

In view of problems in the prior art, as shown in FIG. 2, the present application provides a substrate treating apparatus, the apparatus is configured to perform a thermal atomic layer deposition on the substrate on a tubular PECVD equipment platform. The apparatus comprises: a carrier gas source 202, a plurality of first pipelines 205, a plurality of second pipelines 206, a source bottle 204, an ozone generator 203, a plurality of first fluid valves 210, a plurality of second fluid valves 211, and an apparatus cavity 201. The apparatus cavity 201 is configured to accommodate a substrate and serving as a reaction place thereof. Both the first pipelines 205 and the second pipelines 206 are configured to transmit carrier gas to the apparatus cavity 201. The carrier gas source 202 is configured to supply the carrier gas. The carrier gas is configured to purge the apparatus cavity 201. The ozone generator 203 is configured to supply ozone. The source bottle 204 is configured to accommodate a chemical source. When the carrier gas is introduced into the source bottle 204, the carrier gas carries the chemical source before entering the apparatus cavity 201. The first fluid valves 210 are configured to control the source bottle 204 to communicate with the first pipelines 205. The second fluid valves 211 are configured to control the ozone generator 203 to communicate with the second pipelines 206.

In a plurality of other embodiments, the apparatus further comprises an oxygen source bottle 240, the oxygen source bottle 240 is configured to accommodate purified water. The oxygen source bottle 240 is communicated with the second pipelines 206 through the second fluid valves 211. When opening all the second fluid valves 211 connected with the oxygen source bottle 240, the carrier gas enters the oxygen source bottle 240, and the purified water in the oxygen source bottle 240 enters the apparatus cavity 201 through the second pipelines 206 before participating in a reaction.

In addition, both the oxygen source bottle 240 and the ozone generator 203 may be arranged on the second pipelines at a same time, while selecting an oxygen source by arranging a valve, water can be selected as an oxygen source, and ozone can also be selected as an oxygen source. That is, the oxygen source comprises at least two oxidants with different compositions, communicating with the second pipelines respectively, while at least one oxygen source is an ozone generator, and at least one oxygen source is an oxygen source bottle. Selecting by a valve may further select an oxygen source during each half reaction.

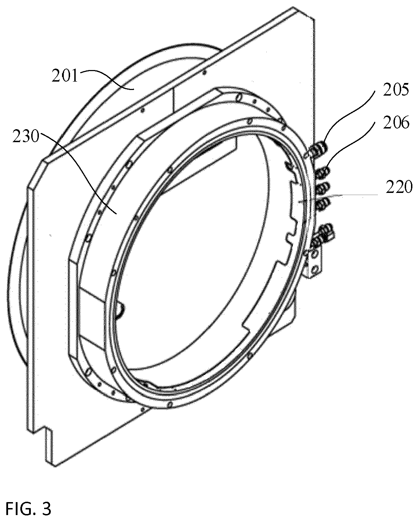

FIG. 3 illustrates a schematic structural diagram on a first apparatus cavity according to an embodiment of the present application.

As shown in FIG. 3, in a plurality of embodiments, the apparatus cavity 201 has a furnace mouth flange 230 connected. The furnace mouth flange 230 has a plurality of gas channels 220 arranged. Both the first pipelines 205 and the second pipelines 206 are connected with the furnace mouth flange 230. Both the first pipelines 205 and the second pipelines 206 are communicated with the apparatus cavity 201 through the plurality of gas channels 220.

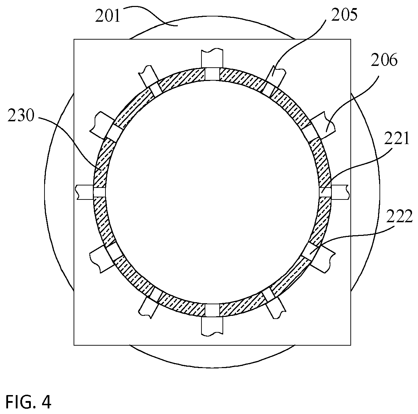

FIG. 4 illustrates a side view of a second apparatus cavity according to an embodiment of the present application.

As shown in FIG. 4, in a plurality of specific embodiments, the apparatus has a plurality of first gas channels 221 and a plurality of second gas channels 222 arranged, and both the plurality of first gas channels 221 and the plurality of second gas channels 222 are annularly distributed on one side of the apparatus cavity 201; the first gas channels 221 are connected with the first pipelines 205; and the second gas channels 222 are connected with the second pipelines 206. Such a design has avoided a premature mixing of the chemical source with the oxide in the first pipelines 205 or the second pipes 206 and the flange, as well as a plurality of associated safety problems. Annular distribution of the gas channels is beneficial for gas to enter the cavity uniformly, thereby avoiding a local gas concentration overhigh, and making a deposition reaction more uniform, thus a uniformity problem of aluminum oxide deposition in a PEALD process is solved. The oxide may be ozone, oxygen, or water. The chemical source may be one or more selected from an aluminum source, a gallium source, a titanium source, and a silicon source.

In a plurality of embodiments, the carrier gas source 202 is configured to supply an inert gas or nitrogen, serving as a source carrier and a purging gas without participating in a deposition reaction. The first fluid valves 210 and the second fluid valves 211 are arranged as a plurality of pneumatic valves. The apparatus cavity 201 is arranged as a quartz tube. The apparatus cavity 201 has two gas inlets arranged, connecting respectively to the first pipelines 205 and the second pipelines 206. The source bottle 204 is located at one side of the first pipelines 205, having an inlet and an outlet, while both the inlet and the outlet of the source bottle 204 are communicated with the first pipelines 205 through two first fluid valves 210 respectively.

It should be noted that, in some embodiments, when the two first fluid valves 210 are both open, the carrier gas flows through the source bottle 204, and the carrier gas carries a chemical source before entering the apparatus cavity 201. The chemical source comprises at least one of the aluminum source, the gallium source, the titanium source, and the silicon source. The aluminum source comprises trimethylaluminum. When the two first fluid valves 210 are both closed, the carrier gas enters the apparatus cavity 201 directly through the first pipelines 205. The second fluid valves 211 are arranged at one side of the second pipelines 206. When the second fluid valves 211 are open, ozone generated by the ozone generator 203 flows to the apparatus cavity 201 through the second pipelines 206. The substrate treating apparatus provided by the present application is applicable to thermal atomic deposition of a plurality of oxides including aluminum oxide, gallium oxide, silicon oxide, titanium oxide and more, which is convenient for selecting a reaction precursor or a chemical source according to a requirement.

In a plurality of other embodiments, the carrier gas source 202 may further be configured to supply a non-reactive gas. The first fluid valves 210 and the second fluid valves 211 are arranged as a solenoid valve or any other kind of valves. The apparatus cavity 201 may be any three-dimensional structure prepared by a plurality of other materials. The apparatus cavity 201 may have more than two gas inlets arranged. The source bottle 204 may be arranged at any position on the first pipelines 205.

In some embodiments, the carrier gas source 202 may have a conversion valve arranged, the conversion valve is configured to supply the carrier gas to the first pipelines 205 or the second pipelines 206 selectively in a same flow. The conversion valve may directly change the carrier gas introduced into the first pipelines 205 to be introduced into the second pipelines 206 with a same flow, may also increase a flow of gas introduced into the second pipelines 206 at a same time of reducing that being introduced into the first pipelines 205 gradually, while the flow reduced in the first pipelines is as same as that increased in the second pipelines, making total flows of gas entering the cavity through the first pipelines 205 and through the second pipelines 206 are a same. Specifically, a three-way structure is adopted, wherein one inlet is the carrier gas source, one outlet has a control valve arranged before connecting with the first pipelines 205, another outlet has a control valve arranged before connecting with the second pipelines 206. Of course, the present application is not specifically limited, and any structure capable of implementing the functions stated above may be adopted.

In a plurality of embodiments, the apparatus further comprises an ozone destructor 207. The ozone destructor 207 is configured to process any excess ozone generated by the ozone generator 203. The ozone destructor 207 has a plurality of beneficial effects including that keeping the ozone generator 203 in a power-on state, having a long-term air flow, thus keeping a flow and a concentration of the ozone being supplied in a stable state, while avoiding excess high-concentration ozone from causing any safety problems to the apparatus and an operator.

In a plurality of embodiments, the ozone generator 203 has a third pipeline 214 and a fourth pipeline 215 connected. The third pipeline 214 is connected with the second fluid valves 211, and the fourth pipeline 215 is connected with the ozone destructor 207. The second pipelines 206, the third pipeline 214, and the fourth pipeline 215 are all subjected to an anti-oxidation treatment.

In a plurality of embodiments, the ozone generator 203 has the third pipeline 214 connected, the third pipeline 214 is communicated with the second pipelines 206, and the third pipeline 214 has a flow meter (not shown in the figures) arranged inside, while the flow meter detects a flow of gas in the third pipeline. The second pipelines 206 have an exhaust pipeline arranged at a place close to the carrier gas source 202. An exhaust pipeline is arranged on the second pipelines 206 at a place close to the carrier gas source 202. By arranging the exhaust pipeline close to the carrier gas source 202, when being open, it is possible to avoid gas flowed into the second pipelines 206 from the third pipeline 214 from being exhausted. The exhaust pipeline comprises a flow controller, and the flow controller controls a flow in the exhaust pipeline to be as same as that of gas detected by the flow meter. When a flow of gas in the third pipeline is as same as that of exhausted gas, a flow of gas flowing into the cavity will not be changed.

When introducing a reaction gas from the source bottle 204, a flow difference before and after introducing the carrier gas into the source bottle 204 is relatively small, thus no additional exhaust structure will be required; of course, when the flow difference before and after introducing the carrier gas into the source bottle 204 is relatively large, the first pipelines 205 also has a corresponding structure arranged, and achieving a same flow by exhausting part of the gas. When adopting the source bottle 204 as an oxygen source to the second pipelines 206, if the flow difference before and after introducing the carrier gas into the source bottle 204 is over large, it is possible to adopt the gas exhaust pipeline of the second pipelines 206 to achieve an adjustment and control of the flow difference, before finally keeping the flow of the gas entering the cavity constant.

In addition, considering the carrier gas source 202 has the conversion valve arranged, the conversion valve is configured to select to supply the carrier gas in a same flow to the first pipelines 205 or the second pipelines 206, such that when carrying out an ALD reaction, a flow of the gas being introduced in a purging process between two half reactions is same, that lowers any variations of gas pressure and flow field between different processes, thereby keeping a constant gas pressure and gas flow during a whole ALD process, thus balancing a reaction process, and ensuring film forming quality and stable performance of a final cell.

In a plurality of specific embodiments, the anti-oxidation treatment comprises coating of aluminum oxide.

In a plurality of other specific embodiments, the anti-oxidation treatment comprises coating of silicon oxide.

In a plurality of other embodiments, the anti-oxidation treatment may comprise coating of any other anti-oxidation materials.

In a plurality of embodiments, the ozone generator 203 is connected with an oxygen source 212 and a nitrogen source 213. The nitrogen source 213 is configured to adjust a concentration of the ozone generated by the ozone generator 203. The ozone concentration is set to [16, 20] wt%.

In a plurality of other embodiments, the ozone generator 203 may be connected with an oxygen source 212 and an inert gas source.

In a plurality of embodiments, the apparatus further comprises a vacuum pump 208. The vacuum pump 208 is configured to pump out gas from the apparatus cavity 201.

In a plurality of other embodiments, the vacuum pump 208 may be arranged as a suction pump or other negative pressure equipment.

In a plurality of embodiments, the apparatus further comprises an exhaust gas treater 209. The exhaust gas treater 209 is configured to process gas pumped out from the apparatus cavity 201. And the exhaust gas treater 209 is also configured to process gas exhausted from the ozone destructor 207.

In a plurality of embodiments, the apparatus cavity 201 has a heater 216 arranged, and the heater 216 is configured to control a reaction temperature of the apparatus cavity 201.

In a plurality of other embodiments, the apparatus cavity 201 further has an auxiliary heat tube (not shown in the figure) arranged, the auxiliary heat tube (not shown in the figures) is configured to heat, such that the apparatus cavity 201 can be rapidly heated up to satisfy a requirement of a silicon nitride process. The auxiliary heat tube is arranged at an inner top of a furnace tube. After the aluminum oxide process is completed in the apparatus cavity 201, the auxiliary heat tube (not shown in the figures) is open to enable a faster temperature rise of the apparatus cavity 201, so as to shorten a temperature rise period as much as possible, and improve processing efficiency.

In a plurality of specific embodiments, an adjustable temperature range of the heater 216 is from room temperature to 530 degree Celsius. It should be noted that, the heater 216 is specifically arranged as a heating wire and a temperature detector; the heating wire is arranged outside the apparatus cavity 201 in an encircling mode, and heat generated by the heating wire is conducted to a substrate in a graphite boat through the apparatus cavity 201; the temperature detector has an inner coupling end, an outer coupling end, and an electrical end; the inner coupling end is arranged inside the apparatus cavity 201 and configured to sense a temperature of the graphite boat; the outer coupling end is arranged outside the apparatus cavity 201 and configured to sense a temperature of the heating wire; and the temperature of the heating wire is controlled by the electrical end, to keep the temperature of the apparatus cavity 201.

In a plurality of other embodiments, the heater 216 may be arranged in any forms, as long as it is possible to achieve an effect of enabling the substrate to reach a desired heating temperature and keeping a continuous temperature control.

In a plurality of embodiments, the apparatus cavity 201 has a plurality of graphite boats arranged inside. A number of the graphite boats is N, and N is a positive integer. The graphite boat is configured to load the substrates. A number of the substrates loaded by the graphite boat is M, and M is a positive integer.

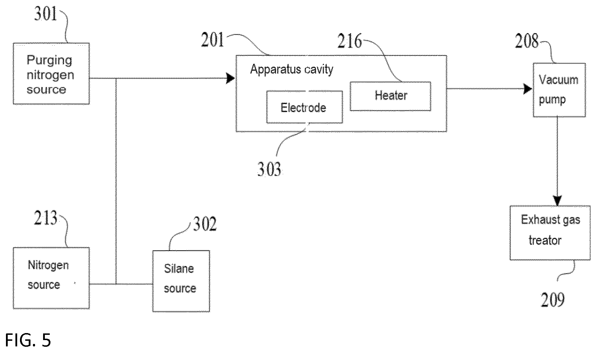

FIG. 5 illustrates a schematic structural diagram on another substrate treating apparatus according to an embodiment of the present application.

It is noted that, in a plurality of other embodiments, as shown in FIG. 5, the apparatus is further configured to carry out a tubular plasma enhanced chemical vapor deposition process in the apparatus cavity 201. The apparatus cavity 201 has an electrode 303 arranged inside, and the apparatus cavity 201 is connected with a purging nitrogen source 301, a nitrogen source 213 and a silane source 302 through a single pipeline, while the nitrogen source 213 and the silane source 302 are transmitting to the apparatus cavity 201 in a mixed way in the single pipeline, achieving the tubular plasma enhanced chemical vapor deposition (PECVD) under an action of an electric field applied by electrifying the electrode 303. The purging nitrogen source 301 is configured to purge the apparatus cavity 201 when a reaction of the plasma enhanced chemical vapor deposition (PECVD) ends.

In a plurality of other embodiments, the apparatus is also capable of carrying out a silicon nitride process of PECVD, silane and ammonia enter the apparatus cavity 201 from the first pipelines 205, and nitrogen is introduced into the apparatus cavity 201 from the nitrogen source 301 through the second pipelines 206. The method avoids a problem that oxide remained in the apparatus cavity 201 after a previous aluminum oxide process reacts with the silane to generate a wrong product, and further avoids a problem that a process time is prolonged due to a long-time purging required by a single gas inlet.

According to another aspect of the present application, a substrate treating apparatus is provided, the apparatus integrates a first processing unit and a second processing unit; the first processing unit comprises: a carrier gas source, a plurality of first pipelines, a plurality of second pipelines, a source bottle, an oxygen source, a plurality of first fluid valves, a plurality of second fluid valves, and an apparatus cavity; wherein
the apparatus cavity is configured to accommodate a substrate and serving as a reaction place for the substrate;
both the first pipelines and the second pipelines are configured to transmit carrier gas to the cavity;
the carrier gas source is configured to supply the carrier gas;
the oxygen source is configured to supply an oxidant;
the source bottle is configured to accommodate a chemical source; when the carrier gas is introduced into the source bottle, the carrier gas carries the chemical source before entering the apparatus cavity;
the first fluid valves are configured to control whether the chemical source flows through the first pipelines or not; and
the second fluid valves are configured to control whether the oxidant flows through the second pipelines or not;
wherein the first processing unit and the second processing unit share at least the carrier gas source and the apparatus cavity.

The present application, due to an arrangement of the pipelines, during a whole ALD process period, gas introduced into the cavity is injected into a vacuum environment through a door end of the cavity before flowing out through an opposite end, wherein a downstream of the gas outflow end has a pump with an inner part entering the cavity arranged, having a gas flow stable, thus, making a flow field of the process gas a stable laminar flow, and the process controlled, therefore being able to improve quality of the film layer, further improving quality of a product.

In a further solution, the first processing unit is a thermal ALD processing unit, and at least one path of gas in the thermal ALD processing unit is introduced into the apparatus cavity in a pulse mode; and the second processing unit is a PECVD processing unit, and gas in the PECVD processing unit is introduced into a same apparatus cavity in a non-pulse mode.

In a further solution, the PECVD processing unit and the thermal ALD processing unit share the carrier gas source and the apparatus cavity.

In a further solution, a vacuum process portion of the tubular equipment is a quartz tube with a hot wall, and a heater is a combination of heating wires or heating plates having not less than four temperature setting intervals.

In a further solution, the PECVD processing unit and the thermal ALD processing unit share the carrier gas source, the source bottle, and the apparatus cavity.

In a further solution, the oxygen source is a gaseous oxygen source or an active plasma oxide.

In a further solution, the plurality of reaction pipelines supply independently gas required by the process to the cavity.

It is noted that the further solutions stated above, as an optional feature set, may be arbitrarily combined, while all are within the scope of protection claimed by the present application.

In a first embodiment of the present application, the carrier gas source has a conversion valve arranged, the conversion valve is configured to select to supply a same flow of the carrier gas to the first pipelines or the second pipelines, that is, the carrier gas source continuously introduces a same flow of the carrier gas into a same tubular cavity through the first pipelines and the second pipelines alternately by the conversion valve, which makes the gas be outputted stably, therefore forming a uniform deposition layer when a first deposition layer, such as aluminum oxide, is deposited in a pulse mode.

In a second embodiment of the present application, the carrier gas source has a conversion valve arranged, the conversion valve is configured to select to supply a same flow of the carrier gas to the first pipelines or the second pipelines, that is, the carrier gas source continuously introduces a same flow of the carrier gas into a same tubular cavity through the first pipelines and the second pipelines alternately by the conversion valve. When the carrier gas is introduced from the carrier gas source into the tubular cavity through the second pipelines by the conversion valve, the gaseous oxygen source (such as an ozone generator) is communicated to the second pipelines through a third pipeline, and the third pipeline has a flow meter arranged inside, while the flow meter is configured to detect a flow of the gas in the third pipeline; and the second pipelines have an exhaust pipeline arranged at a place close to the carrier gas source, the exhaust pipeline comprises a flow controller, the flow controller controls the exhaust pipeline to exhaust gas through the second pipelines, and a flow of the gas being exhausted is as same as the flow detected by the flow meter. The present embodiment can ensure that the flow introduced into the tubular cavity from the second pipeline is unchanged. In such a way, a same flow of the gas can be introduced into the same tubular cavity through the first pipelines and the second pipelines alternately, and the gas can be stably outputted, when a first half reaction step and a second half reaction step are carried out alternately in a later step. Therefore, when a first deposition layer, such as aluminum oxide, is deposited in such a pulse mode, a uniform deposition layer can be formed.

In a first embodiment of the present application, the first processing unit is a thermal atomic layer deposition processing unit (that is, a thermal ALD processing unit), and at least one path of gas in the thermal ALD processing unit is introduced into the apparatus cavity in a pulse mode, so as to form a first deposition layer on the substrate. The second processing unit is a plasma enhanced chemical vapor deposition unit (that is, a PECVD processing unit), gas of the PECVD processing unit is introduced into a same apparatus cavity in a non-pulse mode, so as to further form a second deposition layer different from the first deposition layer on the substrate.

In a second embodiment of the present application, the substrate treating apparatus has a tubular cavity. The first processing unit is a thermal atomic layer deposition processing unit (that is, a thermal ALD processing unit), and at least one path of gas in the thermal ALD processing unit is introduced into the tubular cavity in a pulse mode, so as to form a first deposition layer on the substrate. The second processing unit is a plasma enhanced chemical vapor deposition unit (that is, a PECVD processing unit), gas of the PECVD processing unit is introduced into a same tubular cavity in a non-pulse mode, so as to further form a second deposition layer different from the first deposition layer on the substrate.

It shall be noted herein that the thermal ALD processing adopted in the present application is different from PEALD processing. PEALD processing is complex due to the PEALD processing requiring control of a plasma reaction, having a control process complex.

Wherein, the oxygen source is preferably a gaseous oxygen source.

Due to both the first deposition layer and the second deposition layer being formed in a same apparatus cavity, while the second deposition layer is formed by the plasma enhanced chemical vapor deposition unit in the non-pulse mode, and the first deposition layer is formed by the thermal atomic layer deposition processing unit in the pulse mode, the first deposition layer often cannot be deposited on the substrate uniformly, which affects molding quality of a chip substrate seriously, often leads to an unqualified product.

In order to enable the first deposition layer formed by the thermal atomic layer deposition processing unit to the tubular cavity in the pulse mode to be uniformly deposited on the substrate, the present application provides a plurality of embodiments as follows:
In one embodiment of the present application, the carrier gas source has a conversion valve arranged, and the conversion valve is configured to select to supply the carrier gas in a same flow to the first pipelines or the second pipelines. The present embodiment can ensure that a flow of the gas introduced into the apparatus cavity from the second pipelines is as same as that introduced into the tubular cavity from the first pipelines, thus a flow of gas exhausted from the second pipelines is as same as a flow of the gas in the first pipelines, in such a way, the gas can be outputted stably. Therefore, when a first deposition layer, such as aluminum oxide, is deposited in a pulse mode, a deposition layer will be formed uniformly.

Further, the carrier gas source has the conversion valve arranged, and the conversion valve is configured to select to supply the carrier gas in a same flow to the first pipelines or the second pipelines, that is, the carrier gas source introduces continuously a same flow of the carrier gas into a same tubular cavity alternately through the first pipelines and the second pipelines by the conversion valve. When the gaseous oxygen source (such as an ozone generator) is communicated to the second pipelines through a third pipeline, a flow meter is arranged in the third pipeline, and the flow meter is configured to detect a flow of the gas in the third pipeline; and the second pipelines have an exhaust pipeline arranged at a place close to the carrier gas source, the exhaust pipeline comprises a flow controller, the flow controller controls the exhaust pipeline to exhaust gas from the second pipelines, making a flow of the gas exhausted in the second pipelines is as same as a flow of the gas detected by the flow meter in the third pipeline. The present embodiment can ensure that the flow introduced into the tubular cavity from the second pipelines is unchanged. In such a way, it also achieves that the same flow of gas can be introduced into the same tubular cavity alternately through the first pipelines and the second pipelines, which makes the gas be outputted stably when a first half reaction step and a second half reaction step are carried out alternately. Therefore a deposition layer can be formed uniformly, when a first deposition layer, such as aluminum oxide, is deposited in a pulse mode.

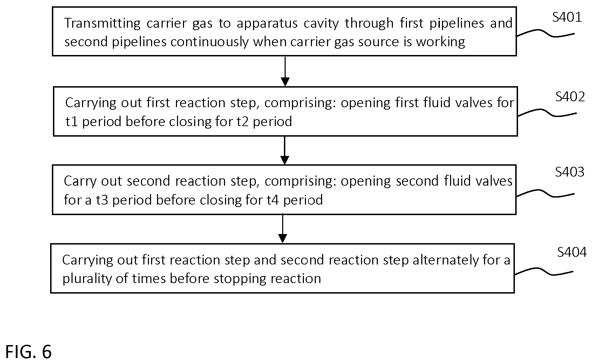

FIG. 6 illustrates a flow diagram on a substrate treating method according to an embodiment of the present application.

Base on the substrate treating apparatus stated above, the present application provides a substrate treating method, applied to the apparatus stated in anyone above. As shown in FIG. 6, the method comprises following steps:
S401. Transmitting the carrier gas to the apparatus cavity 201 through the first pipelines 205 and the second pipelines 206 continuously when the carrier gas source 202 is working.

In a plurality of embodiments, when the substrate enters the apparatus cavity 201, the heater 216 heats up the cavity before heating up the substrate through thermal conduction. The carrier gas source 202 fills the apparatus cavity 201 with the carrier gas to carry out a pressure maintaining test. The vacuum pump 208 pumps out the gas in the apparatus cavity 201. By the conversion valve, the carrier gas source introduces a same flow of carrier gas into the cavity continuously through the first pipelines or the second pipelines. In this way, the present embodiment is able to ensure that a flow of the gas introduced into the apparatus cavity 201 from the second pipelines 206 is as same as that introduced into the apparatus cavity 201 from the first pipelines 205.

In a plurality of specific embodiments, a heating period for the heater 216 to heat up the substrate is 5 to 10 minutes, the heating period depending on a state of the graphite boats and a state of the cavity being heated up. The pressure maintaining test comprises that the apparatus cavity 201 has a pressure change no more than 3Pa in 15s.

S402. Carrying out a first reaction step, comprising: opening the first fluid valves 210 for a t1 period before closing for a t2 period. When the first fluid valves 210 are open, the carrier gas carries the chemical source to enter the apparatus cavity 201 through the first pipelines 205; and when the first fluid valves 210 are closed, the carrier gas source 202 purges the carrier gas into the apparatus cavity 201.

S403. Carry out a second reaction step, comprising: opening the second fluid valves 211 for a t3 period before closing for a t4 period. When the second fluid valves 211 are open, the ozone generator 203 transmits ozone to the apparatus cavity 201 through the second pipelines 206; when the second fluid valves 211 are closed, the carrier gas source 202 purges the carrier gas to the apparatus cavity 201.

S404. Carrying out the first reaction step and the second reaction step alternately for a plurality of times before stopping a reaction.

It is noted that, by carrying out the first reaction step and the second reaction step alternately, the thermal atomic layer deposition is achieved, and the thin film conformality on the substrate surface texturing morphology is improved, while passivated surface damages are avoided, thereby being beneficial for achieving a best passivation effect.

In a plurality of embodiments, after the reaction is stopped, the pipelines and the cavity are purged with the carrier gas, and the vacuum pump 208 stops pumping out gas. After the vacuum is broken, the graphite boats are moved out of the apparatus cavity 201.

In a plurality of embodiments, the ozone generator 203 is kept being on, and excess ozone generated by the ozone generator 203 is processed by the ozone destructor 207. When supplying gas to the second pipelines through the third pipeline, by the exhaust pipeline arranged on the second pipeline at a place close to the carrier gas source, the carrier gas in the second pipelines 206 is exhausted out, while the flow of the gas exhausted is as same as the flow of the gas in the third pipeline.

When the second fluid valves 211 are open, ozone generated by the ozone generator 203 enters the second pipelines 206 through the third pipeline 214, and finally enters the apparatus cavity 201. When the second fluid valves 211 are closed, ozone generated by the ozone generator 203 enters the ozone destructor 207 through the fourth pipeline 215. The ozone destructor 207 destroys most of the ozone, and a small part of the ozone enters the exhaust gas treater 209 for a complete reaction, so as to prevent the ozone from polluting the environment.

In a plurality of embodiments, the gas pumped out from the apparatus cavity 201 by the vacuum pump 208 is introduced into the exhaust gas treater 209. The gas exhausted from the ozone destructor 207 is introduced into the exhaust gas treater 209.

In a plurality of embodiments, the chemical source comprises trimethylaluminum. A surface of the substrate has a layer of hydroxyl arranged, satisfying a following chemical reaction formula: nsurf-OH+Al(CH₃)₃→surf-O-Al(CH₃)₃₋ₙ+nCH₄
wherein, n is 1 or 2.

In a plurality of embodiments, the first reaction step satisfies a following chemical reaction formula:

nsurf-AlOH+Al(CH₃)₃→surf-(nAl)-O-Al(CH₃)₃₋ₙ+nCH₄

wherein, n is 1 or 2. The second reaction step satisfies the following chemical reaction formula:

(3-n)surf-AlCH₃+(3-n)O₃→(3-n)surf-AlCH₂OH+(3-n)O₂

wherein, n is 1 or 2. A product of the second reaction step satisfies a following chemical reaction formula:

2surf-AlCH₂OH→2surf-AlOH+C₂H₄.

It shall be noted that, the ozone in a plurality of reactants of the second reaction step may be partially or completely replaced by purified water. A product obtained at this time still comprises surf-AloOH, which does not affect the first reaction step and the second reaction step to be performed alternately.

In a plurality of embodiments, after the substrate completes the thermal ALD process in the apparatus cavity 201, the substrate continues to subject the PECVD process in the apparatus cavity 201.

It shall be noted that the PECVD processing unit and the thermal ALD processing unit share the carrier gas source and the source bottle.

In a plurality of specific embodiments, a plurality of parameters adopted by the substrate treating method are shown as Table 1, and the temperatures of the apparatus cavity 201 at moments T1-T6 are all set as 200 degrees Celsius. The carrier gas source 202 adopts argon with a flow value of 2500 standard milliliters per minute. A flow value of the ozone is set as 3000 standard milliliters per minute and a concentration as 18.5 wt%. The chemical source adopts trimethylaluminum (TMA). The first fluid valves 210 are open for 5 seconds before being closed for 7 seconds. The second fluid valves 211 are open for 7 seconds before being closed for 8 seconds. An operation of 27 seconds in total stated above is one cycle.

| Table 1 | | | | | | | | | | | | |
|---|---|---|---|---|---|---|---|---|---|---|---|---|
| Temperature (°C) | | | | | | Ar (sccm) | O₃ (sccm) | O₃ ratio | TMA | | O₃ | |
| T1 | T2 | T3 | T4 | T5 | T6 | | | | on(s) | off (s) | on (s) | off (s) |
| 200 | | | | | | 2500 | 3000 | 18.50 wt% | 5 | 7 | 7 | 8 |

In a plurality of specific embodiments, the graphite boats are arranged as eight: A-H. Each graphite boat has 56 substrates loaded, and each substrate has a unique location in the graphite boat. After the cycle has been carried out for 500 times, a thickness test is carried out onto a substrate testing point by an elliptical polarizer.

In a plurality of other embodiments, the temperature may be set as any temperature between [130, 250] degrees Celsius, the carrier gas source 202 may adopt an inert gas or other non-reactive gas, and a flow value may be any positive number. The flow value and the concentration of the ozone can be set as any positive number. An open period and a close period of the first fluid valves 210 and the second fluid valves 211 can be set as any positive number. A number of the graphite boats can be set as any positive integer. Times of the cycle being carried out may be any positive integer number.

According to another aspect of the present application, a substrate treating method is provided. By the treating method, it is possible to keep the flow of the gas in the cavity unchanged during a process of thermal ALD, thereby achieving uniformity of a thin film processed by thermal ALD. That is, the substrate treating method in the present embodiment adopts the substrate treating apparatus in the present application to carry out thermal atomic layer deposition processing (that is, thermal ALD processing) and plasma enhanced chemical vapor deposition processing (that is, PECVD processing) onto the substrate in a same tubular cavity. The thermal ALD processing comprises:
transmitting the carrier gas to the apparatus cavity 201 through the first pipelines and the second pipelines continuously when the carrier gas source is working;
carrying out a first half reaction step, comprising: opening the first fluid valves for a t1 period before closing for a t2 period;
the carrier gas carrying the chemical source before entering the apparatus cavity 201 through the first pipelines, when the first fluid valves are open;
the carrier gas source purging the carrier gas into the apparatus cavity 201, when the first fluid valves are closed;
carrying out a second half reaction step, comprising: opening the second fluid valves for a t3 period before closing for a t4 period;
the ozone generator transmitting ozone to the apparatus cavity 201 through the second pipeline when the second fluid valves are open;
the carrier gas source purging the carrier gas to the apparatus cavity 201 when the second fluid valves are closed; and
carrying out the first reaction step and the second reaction step alternately for a plurality of times before stopping a reaction.

Wherein after the substrate completes the thermal ALD process in the tubular cavity, the substrate continues to subject the PECVD process in the same tubular cavity.

Thus, it is possible to form the first deposition layer in the tubular cavity in a pulse mode based on the thermal ALD processing, including aluminum oxide, silicon oxide, gallium oxide, titanium oxide or other oxides; followed by forming the second deposition layer different from the first deposition layer in the same tubular cavity in a non-pulse mode by the PECVD processing, such as silicon nitride.

Since the first deposition layer and the second deposition layer are formed in the same tubular cavity, and the second deposition layer is formed by the PECVD unit in the non-pulse mode in the tubular cavity, while the first deposition layer is formed by the thermal ALD processing unit in a pulse mode in the same tubular cavity, thus the first deposition layer often cannot be deposited on the substrate uniformly, which affects the molding quality of a chip substrate seriously, and often causes an unqualified product.

In order to enable the first deposition layer formed in the tubular cavity by the thermal atomic layer deposition processing unit in the pulse mode to be deposited uniformly on the substrate, the present application provides a plurality of following embodiments:
In a first embodiment of the present application, when the substrate enters the tubular cavity, the heater heats up the substrate; the carrier gas source fills the carrier gas into the tubular cavity before carrying out a pressure maintaining test, while the vacuum pump pumps out gas in the tubular cavity. Wherein the carrier gas source introduces a same flow of the carrier gas into the tubular cavity alternately through the first pipelines and the second pipelines by the conversion valve. The present embodiment can ensure that the flow of the carrier gas introduced into the apparatus cavity 201 from the second pipelines 206 is as same as that introduced into the apparatus cavity 201 from the first pipelines 205, making the flow of the carrier gas exhausted in the second pipelines is as same as the flow of the carrier gas in the first pipeline. Thus by introducing the same flow of the carrier gas into the tubular cavity alternately through the first pipelines and the second pipelines, the carrier gas can be stably outputted when the first half reaction step and the second half reaction step are carried out alternately. Therefore, it is possible to enable the first deposition layer, such as aluminum oxide, when being deposited in a pulse mode, to form a uniform deposition layer.

In a second embodiment of the present application, when the substrate enters the tubular cavity, the heater heats up the substrate; the carrier gas source fills the carrier gas into the tubular cavity before carrying out a pressure maintaining test, while the vacuum pump pumps out gas in the tubular cavity. Wherein the carrier gas source introduces continuously a same flow of carrier gas into the same tubular cavity alternately through the first pipelines and the second pipelines by the conversion valve. When the carrier gas source introduces the carrier gas into the tubular cavity through the second pipelines by the conversion valve, the ozone generator is communicated to the third pipeline and kept in an on state, the ozone generator introduces the ozone of a first flow into the second pipelines through the third pipeline. The third pipeline has a flow meter arranged in, and the flow meter is configured to detect a flow of the ozone in the third pipeline; meanwhile, the second pipelines has an exhaust pipeline arranged at a place close to the carrier gas source, a flow controller on the exhaust pipeline is configured to control the exhaust pipeline to exhaust gas from the second pipelines, making a flow of the exhausted gas from the second pipelines as same as that of the ozone detected by the flow meter in the third pipeline, so as to ensure a sum of the flow of the carrier gas obtained from the second pipelines and a flow of the ozone obtained from the second pipelines through the third pipeline to be as same as the flow of the carrier gas obtained from the first pipelines. In such a way, it is also possible to achieve a steady output of the gas when the first half reaction step and the second half reaction step are alternately carried out. Therefore, by making the gas be able to be output steadily, it is possible to make a first deposition layer, such as aluminum oxide, form a uniform deposition layer, when being deposited in such a pulse mode.

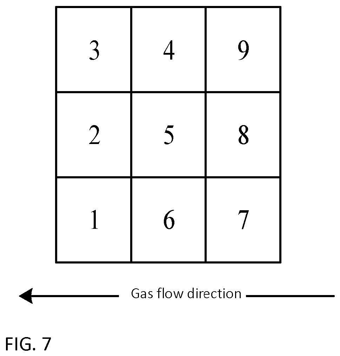

FIG. 7 illustrates a schematic diagram on a region division to the substrate according to the present application.

Further, a thickness test is carried out on the substrate having been treated in the embodiment stated above. As shown in FIG. 7, a method to select testing points of the substrate is: dividing the substrate into nine regions, and taking a center point of each region as a testing point. In an embodiment, the substrate has a side length of 210 mm, a testing result is shown in Table 2: by counting a thickness of 9 testing points in the same substrate (Thickness of SE testing point), it can obtain a mean value (Mean), a within wafer (WIW) uniformity and a thickness growth per cycle (GPC) easily. While a wafer-to-wafer (WTW) uniformity can be obtained by counting the thicknesses of testing points in different substrates.

| Table 2 | | | | | | | | | | | | | |
|---|---|---|---|---|---|---|---|---|---|---|---|---|---|
| Location | Thickness of SE testing point (nm) | | | | | | | | | Mean (nm) | WIW | WT W | GPC (nm/ cycle) |
| | 1 | 2 | 3 | 4 | 5 | 6 | 7 | 8 | 9 | | | | |
| A-3-1 | 52.8 8 | 52.1 8 | 53.4 1 | 53 | 52.7 5 | 52.81 | 54.24 | 53.77 | 53.88 | 53.21 | 1.94 % | 3.01 % | 0.1064 27 |
| A-14-1 | 53.7 3 | 53.1 | 53.8 5 | 54.4 5 | 53.7 1 | 53.62 | 55.45 | 55.9 | 55.07 | 54.32 | 2.58 % | | 0.1086 4 |
| A-26-1 | 52.5 9 | 52.3 2 | 53 | 52.5 7 | 52.6 4 | 52.51 | 53.41 | 53.41 | 52.97 | 52.82 | 1.03 % | | 0.1056 49 |
| B-3-1 | 52.5 5 | 51.5 3 | 53.0 1 | 52.9 | 51.8 2 | 52.27 | 52.73 | 51.39 | 53.04 | 52.36 | 1.58 % | | 0.1047 2 |
| B-14-1 | 53.8 6 | 52.0 1 | 53.3 2 | 53.1 5 | 52.3 3 | 53.4 | 53.38 | 52.44 | 53.43 | 53.04 | 1.74 % | | 0.1060 71 |
| B-26-1 | 52.0 3 | 51.7 | 53.4 9 | 52.6 9 | 51.6 2 | 52.3 | 51.76 | 52.08 | 52.68 | 52.26 | 1.79 % | | 0.1045 22 |
| C-3-1 | 52.6 6 | 51.6 9 | 52.9 2 | 52.5 3 | 51.4 | 52.05 | 52.42 | 51.44 | 52.9 | 52.22 | 1.46 % | | 0.1044 47 |
| C-14-1 | 53.3 4 | 51.9 7 | 53.6 6 | 52.8 4 | 51.8 8 | 53.1 | 53.18 | 51.81 | 52.77 | 52.73 | 1.75 % | | 0.1054 56 |
| C-26-1 | 52.1 6 | 51.6 8 | 52.9 1 | 52.3 5 | 51.4 5 | 51.95 | 52.39 | 51.98 | 52.6 | 52.16 | 1.40 % | | 0.1043 27 |
| D-3-1 | 52.1 3 | 52.0 9 | 52.8 8 | 52.5 3 | 51.5 2 | 52.42 | 51.86 | 51.42 | 52.62 | 52.16 | 1.40 % | | 0.1043 27 |
| D-14-1 | 53.9 8 | 52.3 2 | 52.4 7 | 52.3 1 | 52.0 8 | 53.63 | 53.45 | 52.07 | 52.68 | 52.78 | 1.81 % | | 0.1055 53 |
| D-26-1 | 52.4 4 | 51.4 7 | 52.5 3 | 52.1 7 | 51.0 3 | 51.71 | 51.82 | 51.32 | 51.94 | 51.83 | 1.45 % | | 0.1036 51 |
| E-3-1 | 52.4 4 | 51.2 1 | 52.6 1 | 51.9 8 | 51.4 2 | 51.79 | 52.22 | 52.24 | 51.79 | 51.97 | 1.35 % | | 0.1039 33 |
| E-14-1 | 54.5 7 | 53.6 3 | 52.9 4 | 52.7 | 53.1 | 54.28 | 54.79 | 54.39 | 52.82 | 53.69 | 1.95 % | | 0.1073 82 |
| E-26-1 | 52.4 3 | 50.9 5 | 52.6 8 | 51.9 2 | 50.9 6 | 51.65 | 52.12 | 51.51 | 52.18 | 51.82 | 1.67 % | | 0.1036 44 |
| F-3-1 | 52.4 6 | 51.0 7 | 52 | 51.5 8 | 50.7 | 51.77 | 51.57 | 50.64 | 51.68 | 51.50 | 1.77 % | | 0.1029 93 |
| F-14-1 | 54.3 4 | 53.0 8 | 51.9 5 | 51.7 7 | 52.6 5 | 53.46 | 53.96 | 53.18 | 51.62 | 52.89 | 2.57 % | | 0.1057 8 |
| F-26-1 | 52.6 | 51.1 | 52.0 | 51.2 | 50.4 | 51.73 | 51.99 | 50.23 | 51.73 | 51.46 | 2.33 | | 0.1029 |
| | 3 | 4 | 5 | 2 | 3 | | | | | | % | | 22 |
| G-3-1 | 52.1 8 | 51.0 4 | 51.4 3 | 51.0 2 | 50.3 9 | 51.96 | 51.72 | 50.25 | 51.4 | 51.27 | 1.88 % | | 0.1025 31 |
| G-14-1 | 54.4 | 53.2 2 | 51.7 4 | 51.2 4 | 52.4 | 54.13 | 54.06 | 52.61 | 51.32 | 52.79 | 2.99 % | | 0.1055 82 |
| G-26-1 | 52.0 7 | 50.8 5 | 51.1 | 50.9 6 | 49.9 2 | 51.94 | 52.27 | 50.32 | 51.12 | 51.17 | 2.30 % | | 0.1023 44 |
| H-3-1 | 51.9 9 | 50.8 5 | 50.9 4 | 50.7 8 | 50.7 1 | 52.32 | 52.27 | 50.43 | 51.25 | 51.28 | 1.84 % | | 0.1025 64 |
| H-14-1 | 54.1 7 | 2.87 | 52.0 1 | 51.4 7 | 53.2 | 54.22 | 54.2 | 53.1 | 51.32 | 52.95 | 2.749 | | 0.1059 02 |
| H-26-1 | 52.0 7 | 50.7 5 | 51.1 5 | 51.1 2 | 50.3 1 | 51.79 | 52.37 | 50.63 | 50.84 | 51.23 | 2.01 % | | 0.1024 51 |

It can be easily seen from the Table 2 that, after 500 cycles, the substrate can achieve a WIW uniformity in a range of 0 to 3% and a WTW uniformity in a range of 0 to 3.01%.

In a plurality of other embodiments, the substrate is divided into X regions, and X is a positive integer. A diameter of the substrate is any size smaller than a size of the graphite boat.

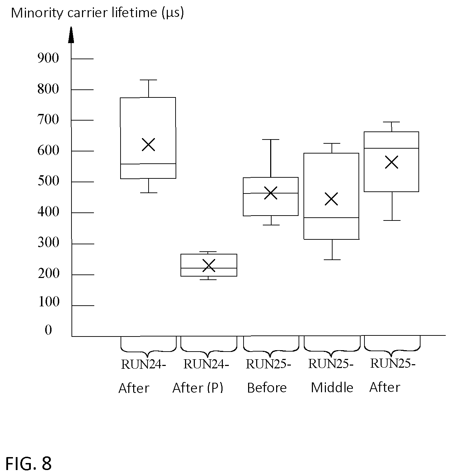

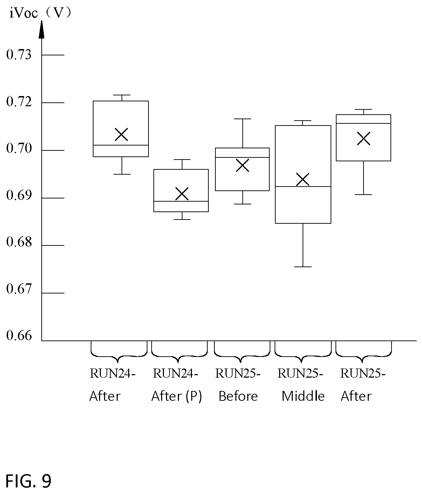

FIG. 8 illustrates a box diagram on a minority carrier lifetime of a substrate according to an embodiment of the present application; and FIG. 9 illustrates a box diagram on an implied open circuit voltage of a substrate according to an embodiment of the present application.

In a plurality of other specific embodiments, the substrate is coated with 15 nm aluminum oxide on both sides by the substrate treating method, before being vacuum annealed at 450°C for 30 minutes. A minority carrier lifetime of the substrate after the process is debugged and stabilized is tested by sintoninstrument WCT-120 or other measurement equipment. As an embodiment, a 24th process and a 25th process in a process development process are selected as experimental samples in the present embodiment; and testing results are shown in FIG. 8. Wherein a mean of the minority carrier lifetimes of an n-type substrate is higher than 450 µs, while a mean of minority carrier lifetimes of a p-type substrate is higher than 200 µs. Results of a test on an implied open circuit voltage (iVOC) of the substrate in the 24th and the 25th process experiments are shown in FIG. 9. Wherein a mean of iVOC at each time node is higher than 0.69 V, that is, both a previous passivation level and a subsequent passivation level are at a relatively high level. It is noted that, the minority carrier lifetime and the iVOC are in a variation trend of positive correlation.

In summary, for a plurality of applications of a TOPCon cell, the embodiment of the present application is able to carry out a uniform aluminum oxide deposition on a large-size substrate, especially having an excellent conformality and passivation effect on a texturing surface of an n-type substrate, ensuring an efficient utilization of light energy by the TOPCon cell. In the embodiment of the present application, since the PECVD equipment platform is reused when the substrate is subjected to thermal atomic deposition, a process of both aluminum oxide and silicon nitride in a same boat is achieved, thereby production cost is reduced to a certain extent.

While the embodiments of the present application have been described in detail above, it will be apparent to those skilled in the art that various modifications and variations can be made to the embodiments. It should be understood, however, that such modifications and variations are within the scope of the present application as set forth in the claims. Moreover, the present application described herein is capable of other embodiments and of being practiced or of being carried out in various ways.

## Claims

1. A substrate treating apparatus, wherein integrating a thermal ALD processing unit and a PECVD processing unit; the thermal ALD processing unit comprising: a carrier gas source (202), a plurality of first pipelines (205), a plurality of second pipelines (206), a source bottle (204), an oxygen source (212), a plurality of first fluid valves (210), a plurality of second fluid valves (211) and an apparatus cavity (201);
the apparatus cavity (201) is configured to accommodate a substrate and serve as a reaction place for the substrate;
both the first pipelines (205) and the second pipelines (206) are configured to transmit carrier gas to the apparatus cavity (201);
the carrier gas source (202) is configured to supply the carrier gas; the oxygen source (212) is configured to supply an oxidant;
the source bottle (204) is configured to accommodate a chemical source; the carrier gas source (202) is connected to the apparatus cavity (201) through the first pipelines (205), the source bottle (204) and the first pipeline (205) are arranged in parallel such that the carrier gas can flow through at least one of the source bottle (204) and the first pipelines (205);
the first fluid valves (210) are configured to control whether the chemical source flows through the first pipelines (205) or not;
the second fluid valves (211) are configured to control whether the oxidant flows through the second pipelines (206) or not;
**characterized in that**
the substrate treating apparatus has a plurality of first gas channels (221) and a plurality of second gas channels (222) arranged, and both the plurality of first gas channels (221) and the plurality of second gas channels (222) are annularly distributed on one side of the apparatus cavity (201); the first gas channels (221) are connected with the first pipelines (205); and the second gas channels (222) are connected with the second pipelines (206); and
the carrier gas source (202) has a conversion valve arranged, and the conversion valve is configured to select to supply the carrier gas in a same flow to the first pipelines (205) or the second pipelines (206), such that the carrier gas source (202) continuously introduces the same flow of the carrier gas into the apparatus cavity (201) through the first pipelines (205) and the second pipelines (206) alternately by the conversion valve.

2. The substrate treating apparatus according to claim 1, wherein the oxygen source (212) comprises at least two oxidants of different compositions, communicated with the second pipelines (206) respectively.

3. The substrate treating apparatus according to claim 2, wherein at least one oxygen source (212) is an ozone generator (203), and at least one oxygen source (212) is an oxygen source bottle (240).

4. The substrate treating apparatus according to claim 3, wherein the ozone generator (203) has a third pipeline (214) connected, the third pipeline (214) is communicated with the second pipelines (206), the third pipeline (214) has a flow meter arranged inside, and the flow meter is configured to detect a flow of the gas in the third pipeline (214); and
the second pipelines (206) have an exhaust pipeline arranged at a place close to the carrier gas source (202), the exhaust pipeline comprises a flow controller, the flow controller controls the exhaust pipeline to exhaust gas through the second pipelines (206), and a flow of the gas being exhausted is as same as the flow detected by the flow meter.

5. The substrate treating apparatus according to claim 1, wherein the apparatus cavity (201) has a furnace mouth flange (230) arranged; both the first pipelines (205) and the second pipelines (206) are connected with the furnace mouth flange (230); and
the furnace mouth flange (230) has a plurality of gas channels (220) arranged, each gas channel (220) is configured to communicate the apparatus cavity (201) with the first pipelines (205) or the second pipelines (206) respectively.

6. The substrate treating apparatus according to claim 3, wherein further comprising an ozone destructor (207);
the ozone destructor (207) is configured to process any excess ozone generated by the ozone generator (203);
the ozone generator (203) has the third pipeline (214) and a fourth pipeline (215) connected;
the third pipeline (214) is connected with the second fluid valves (211), and the fourth pipeline (215) is connected with the ozone destructor (207).

7. The substrate treating apparatus according to any one of claims 1-6, wherein each pipeline is subjected to an anti-oxidation treatment.

8. The substrate treating apparatus according to claim 7, wherein
the anti-oxidation treatment comprises coating with aluminum oxide.

9. The substrate treating apparatus according to claim 3, wherein
the ozone generator (203) is connected with an oxygen source (212) and a nitrogen source (213); and
the nitrogen source (213) is configured to control a concentration of the ozone generated by the ozone generator (203); and a concentration of the ozone is set as [16, 20] wt%.

10. The substrate treating apparatus according to claim 1, wherein the apparatus cavity (201) comprises a heater (216), configured to control a reaction temperature of the apparatus cavity (201).

11. The substrate treating apparatus according to claim 1, wherein the PECVD processing unit and the thermal ALD processing unit sharing the carrier gas source (202) and the source bottle (204).

12. A substrate treating method, adopting the substrate treating apparatus according to claim 1, carrying out thermal ALD and PECVD processing on a substrate in a same cavity, wherein in the substrate treating apparatus, the oxygen source (212) comprises at least two oxidants of different compositions communicated with the second pipelines (206) respectively, at least one oxygen source (212) is an ozone generator (203), and at least one oxygen source (212) is an oxygen source bottle (240); the ozone generator (203) has a third pipeline (214) connected, and the third pipeline (214) is communicated with the second pipelines (206);
wherein the thermal ALD processing comprising:
transmitting the carrier gas to the apparatus cavity (201) through the first pipelines (205) and the second pipelines (206) continuously when the carrier gas source (202) is working;
carrying out a first reaction step, comprising: opening the first fluid valves (210) for a t1 period before closing for a t2 period;
the carrier gas carrying the chemical source before entering the apparatus cavity (201) through the first pipelines (205), when the first fluid valves (210) are open;
and the carrier gas source (202) purging the carrier gas into the apparatus cavity (201) when the first fluid valves (210) are closed;
carrying out a second reaction step, comprising: opening the second fluid valves (211) for a t3 period before closing for a t4 period;
the ozone generator (203) transmitting ozone to the apparatus cavity (201) through the second pipelines (206) when the second fluid valves (211) are open;
the carrier gas source (202) purging the carrier gas to the apparatus cavity (201) when the second fluid valves (211) are closed; and
carrying out the first reaction step and the second reaction step alternately for a plurality of times before stopping a reaction.

13. The substrate treating method according to claim 12, wherein in the substrate treating apparatus, the apparatus cavity (201) comprises a heater (216), configured to control a reaction temperature of the apparatus cavity (201);
when the substrate enters the apparatus cavity (201), the heater (216) heats up the substrate; and
the carrier gas source (202) fills the apparatus cavity (201) with the carrier gas, and the carrier gas source (202) introduces continuously a same flow of the carrier gas into the cavity through the first pipelines (205) or the second pipelines (206) by the conversion valve.

14. The substrate treating method according to claim 12, wherein the substrate treating apparatus further comprises an ozone destructor (207); the ozone destructor (207) is configured to process any excess ozone generated by the ozone generator (203); the ozone generator (203) has the third pipeline (214) and a fourth pipeline (215) connected, and the fourth pipeline (215) is connected with the ozone destructor (207); the ozone generator (203) is kept in an on state, and excess ozone generated by the ozone generator (203) is treated by the ozone destructor (207).

15. The substrate treating method according to claim 12, wherein the ozone generator (203) is kept in the on state, when supplying gas to the second pipelines (206) through the third pipeline (214), the exhaust pipeline arranged on the second pipeline and close to the carrier gas source (202) exhausts the carrier gas in the second pipelines (206) out, and a flow of the gas exhausted is as same as a flow of the gas in the third pipeline (214).

16. The substrate treating method according to claim 14, wherein the substrate treating apparatus further comprises a vacuum pump (208) and an exhaust gas treater (209), wherein the vacuum pump (208) is respectively connected to the apparatus cavity (201) and the exhaust gas treater (209), and the exhaust gas treater (209) is further connected to the ozone destructor (207);
gas pumped out from the apparatus cavity (201) by the vacuum pump (208) is introduced into the exhaust gas treater (209); and
gas exhausted from the ozone destructor (207) is introduced into the exhaust gas treater (209).

17. The substrate treating method according to claim 12, wherein the substrate continuing to perform the PECVD process in the apparatus cavity (201), after the substrate completing the thermal ALD process in the apparatus cavity (201).

## Patentansprüche

1. Substratbehandlungsvorrichtung, wobei eine thermische ALD-Bearbeitungseinheit und eine PECVD-Bearbeitungseinheit integriert sind, wobei die thermische ALD-Bearbeitungseinheit Folgendes umfasst: eine Trägergasquelle (202), eine Vielzahl von ersten Rohrleitungen (205), eine Vielzahl von zweiten Rohrleitungen (206), eine Quellenflasche (204), eine Sauerstoffquelle (212), eine Vielzahl von ersten Fluidventilen (210), eine Vielzahl von zweiten Fluidventilen (211) und einen Vorrichtungshohlraum (201),
wobei der Vorrichtungshohlraum (201) dazu eingerichtet ist, ein Substrat aufzunehmen und als Reaktionsort für das Substrat zu dienen,
wobei sowohl die ersten Rohrleitungen (205) als auch die zweiten Rohrleitungen (206) dazu eingerichtet sind, Trägergas zum Vorrichtungshohlraum (201) zu übertragen,
wobei die Trägergasquelle (202) dazu eingerichtet ist, das Trägergas zu liefern, wobei die Sauerstoffquelle (212) dazu eingerichtet ist, ein Oxidationsmittel zu liefern,
wobei die Quellenflasche (204) dazu eingerichtet ist, eine chemische Quelle aufzunehmen, wobei die Trägergasquelle (202) über die ersten Rohrleitungen (205) mit dem Vorrichtungshohlraum (201) verbunden ist, wobei die Quellenflasche (204) und die erste Rohrleitung (205) parallel angeordnet sind, so dass das Trägergas durch mindestens eine der Quellenflasche (204) und der ersten Rohrleitungen (205) fließen kann,
wobei die ersten Fluidventile (210) dazu eingerichtet sind, zu steuern, ob die chemische Quelle durch die ersten Rohrleitungen (205) fließt oder nicht,
wobei die zweiten Fluidventile (211) dazu eingerichtet sind, zu steuern, ob das Oxidationsmittel durch die zweiten Rohrleitungen (206) fließt oder nicht,
**dadurch gekennzeichnet, dass**
die Substratbehandlungsvorrichtung eine Vielzahl von ersten Gaskanälen (221) und eine Vielzahl von zweiten Gaskanälen (222) aufweist, wobei sowohl die Vielzahl von ersten Gaskanälen (221) als auch die Vielzahl von zweiten Gaskanälen (222) ringförmig auf einer Seite des Vorrichtungshohlraums (201) verteilt sind, wobei die ersten Gaskanäle (221) mit den ersten Rohrleitungen (205) verbunden sind, wobei die zweiten Gaskanäle (222) mit den zweiten Rohrleitungen (206) verbunden sind, und
wobei die Trägergasquelle (202) ein Umschaltventil aufweist, das dazu eingerichtet ist, zu wählen, das Trägergas in einem gleichen Durchfluss den ersten Rohrleitungen (205) oder den zweiten Rohrleitungen (206) zu liefern, so dass die Trägergasquelle (202) mittels des Umschaltventils abwechselnd kontinuierlich den gleichen Durchfluss des Trägergases durch die ersten Rohrleitungen (205) und die zweiten Rohrleitungen (206) in den Vorrichtungshohlraum (201) einleitet.

2. Substratbehandlungsvorrichtung nach Anspruch 1, wobei die Sauerstoffquelle (212) mindestens zwei Oxidationsmittel unterschiedlicher Zusammensetzung umfasst, die jeweils mit den zweiten Rohrleitungen (206) kommunizieren.

3. Substratbehandlungsvorrichtung nach Anspruch 2, wobei mindestens eine Sauerstoffquelle (212) ein Ozongenerator (203) ist und mindestens eine Sauerstoffquelle (212) eine Sauerstoffquellenflasche (240) ist.

4. Substratbehandlungsvorrichtung nach Anspruch 3, wobei der Ozongenerator (203) mit einer dritten Rohrleitung (214) verbunden ist, wobei die dritte Rohrleitung (214) mit den zweiten Rohrleitungen (206) kommuniziert, wobei die dritte Rohrleitung (214) einen darin angeordneten Durchflussmesser aufweist, und wobei der Durchflussmesser dazu eingerichtet ist, einen Durchfluss des Gases in der dritten Rohrleitung (214) zu erfassen, und
wobei die zweiten Rohrleitungen (206) eine Abgasrohrleitung aufweisen, die an einer Stelle in der Nähe der Trägergasquelle (202) angeordnet ist, wobei die Abgasrohrleitung einen Durchflussregler umfasst, wobei der Durchflussregler die Abgasrohrleitung steuert, um Gas durch die zweiten Rohrleitungen (206) abzulassen, und wobei ein Durchfluss des abgelassenen Gases dem vom Durchflussmesser erfassten Durchfluss gleicht.

5. Substratbehandlungsvorrichtung nach Anspruch 1, wobei der Vorrichtungshohlraum (201) einen Ofenmundflansch (230) aufweist, wobei sowohl die ersten Rohrleitungen (205) als auch die zweiten Rohrleitungen (206) mit dem Ofenmundflansch (230) verbunden sind, und
wobei der Ofenmundflansch (230) eine Vielzahl von Gaskanälen (220) aufweist, wobei jeder Gaskanal (220) dazu eingerichtet ist, den Vorrichtungshohlraum (201) jeweils mit den ersten Rohrleitungen (205) oder den zweiten Rohrleitungen (206) zu kommunizieren.

6. Substratbehandlungsvorrichtung nach Anspruch 3, wobei sie ferner einen Ozonzerstörer (207) umfasst,
wobei der Ozonzerstörer (207) dazu eingerichtet ist, jegliches vom Ozongenerator (203) erzeugte überschüssige Ozon zu bearbeiten,
wobei der Ozongenerator (203) mit der dritten Rohrleitung (214) und einer vierten Rohrleitung (215) verbunden ist,
wobei die dritte Rohrleitung (214) mit den zweiten Fluidventilen (211) verbunden ist, und wobei die vierte Rohrleitung (215) mit dem Ozonzerstörer (207) verbunden ist.

7. Substratbehandlungsvorrichtung nach einem der Ansprüche 1 bis 6, wobei jede Rohrleitung einer Antioxidationsbehandlung unterzogen wird.

8. Substratbehandlungsvorrichtung nach Anspruch 7, wobei
die Antioxidationsbehandlung ein Beschichten mit Aluminiumoxid umfasst.

9. Substratbehandlungsvorrichtung nach Anspruch 3, wobei
der Ozongenerator (203) mit einer Sauerstoffquelle (212) und einer Stickstoffquelle (213) verbunden ist, und
wobei die Stickstoffquelle (213) dazu eingerichtet ist, eine Konzentration des vom Ozongenerator (203) erzeugten Ozons zu steuern, und wobei eine Konzentration des Ozons auf [16, 20] Gew.-% eingestellt ist.

10. Substratbehandlungsvorrichtung nach Anspruch 1, wobei der Vorrichtungshohlraum (201) eine Heizvorrichtung (216) umfasst, die dazu eingerichtet ist, eine Reaktionstemperatur des Vorrichtungshohlraums (201) zu steuern.

11. Substratbehandlungsvorrichtung nach Anspruch 1, wobei die PECVD-Bearbeitungseinheit und die thermische ALD-Bearbeitungseinheit sich die Trägergasquelle (202) und die Quellenflasche (204) teilen.

12. Substratbehandlungsverfahren , bei dem die Substratbehandlungsvorrichtung nach Anspruch 1 verwendet wird, um eine thermische ALD- und PECVD- Bearbeitung an einem Substrat in derselben Kavität durchzuführen, wobei in der Substratbehandlungsvorrichtung die Sauerstoffquelle (212) mindestens zwei Oxidationsmittel unterschiedlicher Zusammensetzung umfasst, die jeweils mit den zweiten Rohrleitungen (206) kommunizieren, wobei mindestens eine Sauerstoffquelle (212) ein Ozongenerator (203) ist und mindestens eine Sauerstoffquelle (212) eine Sauerstoffflasche (240) ist, wobei der Ozongenerator (203) mit einer dritten Rohrleitung (214) verbunden ist und die dritte Rohrleitung (214) mit den zweiten Rohrleitungen (206) kommuniziert,
wobei die thermische ALD- Bearbeitung Folgendes umfasst:
kontinuierliches Übertragen des Trägergases in den Vorrichtungshohlraum (201) durch die ersten Rohrleitungen (205) und die zweiten Rohrleitungen (206), wenn die Trägergasquelle (202) in Betrieb ist;
Durchführen eines ersten Reaktionsschritts, der Folgendes umfasst: Öffnen der ersten Fluidventile (210) für einen Zeitraum t1, bevor sie für einen Zeitraum t2 geschlossen werden;
Tragen der chemischen Quelle durch das Trägergas vor dem Eintreten in den Vorrichtungshohlraum (201) durch die ersten Rohrleitungen (205), wenn die ersten Fluidventile (210) geöffnet sind;
und Spülen des Trägergases durch die Trägergasquelle (202) in den Vorrichtungshohlraum (201), wenn die ersten Fluidventile (210) geschlossen sind;
Durchführen eines zweiten Reaktionsschritts, der Folgendes umfasst: Öffnen der zweiten Fluidventile (211) für einen Zeitraum t3, bevor sie für einen Zeitraum t4 geschlossen werden;
Übertragen von Ozon durch den Ozongenerator (203) über die zweiten Rohrleitungen (206) zu dem Vorrichtungshohlraum (201), wenn die zweiten Fluidventile (211) geöffnet sind;
Spülen des Trägergases durch die Trägergasquelle (202) in den Vorrichtungshohlraum (201), wenn die zweiten Fluidventile (211) geschlossen sind; und
Durchführen des ersten Reaktionsschritts und des zweiten Reaktionsschritts abwechselnd für eine Vielzahl von Malen, bevor eine Reaktion gestoppt wird.

13. Substratbehandlungsverfahren nach Anspruch 12, wobei der Vorrichtungshohlraum (201) in der Substratbehandlungsvorrichtung eine Heizvorrichtung (216) umfasst, die dazu eingerichtet ist, eine Reaktionstemperatur des Vorrichtungshohlraums (201) zu steuern,
wobei, wenn das Substrat in den Vorrichtungshohlraum (201) eintritt, die Heizvorrichtung (216) das Substrat erwärmt, und
wobei die Trägergasquelle (202) den Vorrichtungshohlraum (201) mit dem Trägergas füllt und die Trägergasquelle (202) kontinuierlich einen gleichen Durchfluss des Trägergases durch die ersten Rohrleitungen (205) oder die zweiten Rohrleitungen (206) mittels des Umschaltventils in den Hohlraum einleitet.

14. Substratbehandlungsverfahren nach Anspruch 12, wobei die Substratbehandlungsvorrichtung ferner einen Ozonzerstörer (207) umfasst, wobei der Ozonzerstörer (207) dazu eingerichtet ist, jegliches vom Ozongenerator (203) erzeugte überschüssige Ozon zu bearbeiten, wobei der Ozongenerator (203) mit der dritten Rohrleitung (214) und einer vierten Rohrleitung (215) verbunden ist und die vierte Rohrleitung (215) mit dem Ozonzerstörer (207) verbunden ist, wobei der Ozongenerator (203) in einem eingeschalteten Zustand gehalten wird, und wobei überschüssiges durch den Ozongenerator (203) erzeugtes Ozon durch den Ozonzerstörer (207) behandelt wird.

15. Substratbehandlungsverfahren nach Anspruch 12, wobei der Ozongenerator (203) im eingeschalteten Zustand gehalten wird, wenn Gas über die dritte Rohrleitung (214) in die zweiten Rohrleitungen (206) geliefert wird, wobei die an der zweiten Rohrleitung und in der Nähe der Trägergasquelle (202) angeordnete Abgasrohrleitung das Trägergas in den zweiten Rohrleitungen (206) ablässt, und wobei ein Durchfluss des abgelassenen Gases dem Durchfluss des Gases in der dritten Rohrleitung (214) gleicht.

16. Substratbehandlungsverfahren nach Anspruch 14, wobei die Substratbehandlungsvorrichtung ferner eine Vakuumpumpe (208) und ein Abgasbehandlungsgerät (209) umfasst, wobei die Vakuumpumpe (208) jeweils mit dem Vorrichtungshohlraum (201) und dem Abgasbehandlungsgerät (209) verbunden ist, und wobei das Abgasbehandlungsgerät (209) ferner mit dem Ozonzerstörer (207) verbunden ist,
wobei ein von der Vakuumpumpe (208) aus dem Vorrichtungshohlraum (201) abgepumptes Gas in das Abgasbehandlungsgerät (209) eingeleitet wird, und
wobei ein aus dem Ozonzerstörer (207) abgelassenes Gas in das Abgasbehandlungsgerät (209) eingeleitet wird.

17. Substratbehandlungsverfahren nach Anspruch 12, wobei das Substrat den PECVD-Prozess in dem Vorrichtungshohlraum (201) weiter durchführt, nachdem das Substrat den thermischen ALD-Prozess in dem Vorrichtungshohlraum (201) abgeschlossen hat.

## Revendications

1. Appareil de traitement de substrat, dans lequel il intègre une unité de traitement ALD thermique et une unité de traitement PECVD ; l'unité de traitement ALD thermique comprenant : une source de gaz vecteur (202), une pluralité de premières conduites (205), une pluralité de deuxièmes conduites (206), une bouteille source (204), une source d'oxygène (212), une pluralité de premières vannes de fluide (210), une pluralité de secondes vannes de fluide (211) et une cavité d'appareil (201) ;
la cavité d'appareil (201) est conçue pour recevoir un substrat et servir d'emplacement de réaction pour le substrat ;
les premières conduites (205) et les deuxièmes conduites (206) sont toutes deux conçues pour transmettre du gaz vecteur à la cavité d'appareil (201) ;
la source de gaz vecteur (202) est conçue pour fournir le gaz vecteur ; la source d'oxygène (212) est conçue pour fournir un oxydant ;
la bouteille source (204) est conçue pour loger une source chimique ; la source de gaz vecteur (202) est reliée à la cavité d'appareil (201) par l'intermédiaire des premières conduites (205), la bouteille source (204) et la première conduite (205) sont disposées en parallèle de sorte que le gaz vecteur puisse s'écouler à travers au moins l'une de la bouteille source (204) et des premières conduites (205) ;
les premières vannes de fluide (210) sont conçues pour commander si la source chimique s'écoule ou non à travers les premières conduites (205) ;
les secondes vannes de fluide (211) sont conçues pour commander si l'oxydant s'écoule ou non à travers les deuxièmes conduites (206) ;
**caractérisé en ce que**
l'appareil de traitement de substrat a une pluralité de premiers canaux de gaz (221) et une pluralité de seconds canaux de gaz (222) disposés, et la pluralité de premiers canaux de gaz (221) et la pluralité de seconds canaux de gaz (222) sont répartis de manière annulaire sur un côté de la cavité d'appareil (201) ; les premiers canaux de gaz (221) sont reliés aux premières conduites (205) ; et les seconds canaux de gaz (222) sont reliés aux deuxièmes conduites (206) ; et
la source de gaz vecteur (202) a une vanne de conversion disposée, et la vanne de conversion est conçue pour sélectionner pour fournir le gaz vecteur dans un même écoulement aux premières conduites (205) ou aux deuxièmes conduites (206), de sorte que la source de gaz vecteur (202) introduise en continu le même écoulement du gaz vecteur dans la cavité d'appareil (201) à travers les premières conduites (205) et les deuxièmes conduites (206) alternativement par la vanne de conversion.

2. Appareil de traitement de substrat selon la revendication 1, dans lequel la source d'oxygène (212) comprend au moins deux oxydants de compositions différentes qui sont respectivement en communication avec les deuxièmes conduites (206).

3. Appareil de traitement de substrat selon la revendication 2, dans lequel au moins une source d'oxygène (212) est un générateur d'ozone (203) et au moins une source d'oxygène (212) est une bouteille source d'oxygène (240).

4. Appareil de traitement de substrat selon la revendication 3, dans lequel le générateur d'ozone (203) a une troisième conduite (214) reliée, la troisième conduite (214) est en communication avec les deuxièmes conduites (206), la troisième conduite (214) a un débitmètre disposé à l'intérieur, et le débitmètre est conçu pour détecter un écoulement du gaz dans la troisième conduite (214) ; et
les deuxièmes conduites (206) ont une conduite d'échappement disposée au niveau d'un emplacement proche de la source de gaz vecteur (202), la conduite d'échappement comprend un régulateur d'écoulement, le régulateur d'écoulement commande la conduite d'échappement pour évacuer du gaz par les deuxièmes conduites (206), et l'écoulement du gaz évacué est identique à l'écoulement détecté par le débitmètre.

5. Appareil de traitement de substrat selon la revendication 1, dans lequel la cavité d'appareil (201) a un rebord d'embouchure de four (230) ; les premières conduites (205) et les deuxièmes conduites (206) sont toutes deux reliées au rebord d'embouchure de four (230) ; et
le rebord d'embouchure de four (230) a une pluralité de canaux de gaz (220) disposés, chaque canal de gaz (220) est conçu pour mettre en communication la cavité d'appareil (201) avec les premières conduites (205) ou les deuxièmes conduites (206) respectivement.

6. Appareil de traitement de substrat selon la revendication 3, dans lequel il comprend en outre un destructeur d'ozone (207) ;
le destructeur d'ozone (207) est conçu pour traiter tout excès d'ozone généré par le générateur d'ozone (203) ;
le générateur d'ozone (203) a une troisième conduite (214) et une quatrième conduite (215) reliées ;
la troisième conduite (214) est reliée aux secondes vannes de fluide (211), et la quatrième conduite (215) est reliée au destructeur d'ozone (207).

7. Appareil de traitement de substrat selon l'une quelconque des revendications 1 à 6, dans lequel chaque conduite est soumise à un traitement anti-oxydation.

8. Appareil de traitement de substrat selon la revendication 7, dans lequel
le traitement anti-oxydation comprend un revêtement à l'oxyde d'aluminium.

9. Appareil de traitement de substrat selon la revendication 3, dans lequel
le générateur d'ozone (203) est relié à une source d'oxygène (212) et à une source d'azote (213) ; et
la source d'azote (213) est conçue pour commander une concentration de l'ozone généré par le générateur d'ozone (203) ; et une concentration de l'ozone est fixée à [16, 20] % en poids.

10. Appareil de traitement de substrat selon la revendication 1, dans lequel la cavité d'appareil (201) comprend un dispositif de chauffage (216) conçu pour commander une température de réaction de la cavité d'appareil (201).

11. Appareil de traitement de substrat selon la revendication 1, dans lequel l'unité de traitement PECVD et l'unité de traitement ALD thermique partagent la source de gaz vecteur (202) et la bouteille source (204).

12. Procédé de traitement de substrat consistant à utiliser l'appareil de traitement de substrat selon la revendication 1, à effectuer un traitement ALD thermique et un traitement PECVD sur un substrat dans une même cavité, dans lequel, dans l'appareil de traitement de substrat, la source d'oxygène (212) comprend au moins deux oxydants de compositions différentes qui sont respectivement en communication avec les deuxièmes conduites (206), au moins une source d'oxygène (212) est un générateur d'ozone (203), et au moins une source d'oxygène (212) est une bouteille source d'oxygène (240) ; le générateur d'ozone (203) est relié à une troisième conduite (214) reliée, et la troisième conduite (214) est en communication avec les deuxièmes conduites (206) ;
dans lequel le traitement ALD thermique comprend :
la transmission du gaz vecteur à la cavité d'appareil (201) à travers les premières conduites (205) et les deuxièmes conduites (206) de manière continue lorsque la source de gaz vecteur (202) fonctionne ;
la réalisation d'une première étape de réaction, comprenant : l'ouverture des premières vannes de fluide (210) pendant une période t1 avant de les fermer pendant une période t2 ;
le gaz vecteur transportant la source chimique avant d'entrer dans la cavité d'appareil (201) à travers les premières conduites (205), lorsque les premières vannes de fluide (210) sont ouvertes ;
et la source de gaz vecteur (202) évacuant le gaz vecteur dans la cavité d'appareil (201) lorsque les premières vannes de fluide (210) sont fermées ;
la réalisation d'une seconde étape de réaction, comprenant : l'ouverture des secondes vannes de fluide (211) pendant une période t3 avant de les fermer pendant une période t4 ;
le générateur d'ozone (203) transmettant de l'ozone à la cavité d'appareil (201) à travers les deuxièmes conduites (206) lorsque les secondes vannes de fluide (211) sont ouvertes ;
la source de gaz vecteur (202) évacuant le gaz vecteur vers la cavité d'appareil (201) lorsque les secondes vannes de fluide (211) sont fermées ; et
le fait d'effectuer la première étape de réaction et la seconde étape de réaction alternativement plusieurs fois avant d'arrêter une réaction.

13. Procédé de traitement de substrat selon la revendication 12, dans lequel, dans l'appareil de traitement de substrat, la cavité d'appareil (201) comprend un dispositif de chauffage (216) conçu pour commander une température de réaction de la cavité d'appareil (201) ;
lorsque le substrat pénètre dans la cavité d'appareil (201), le dispositif de chauffage (216) chauffe le substrat ; et
la source de gaz vecteur (202) remplit la cavité d'appareil (201) avec le gaz vecteur, et la source de gaz vecteur (202) introduit en continu un même écoulement de gaz vecteur dans la cavité à travers les premières conduites (205) ou les deuxièmes conduites (206) par la vanne de conversion.

14. Procédé de traitement de substrat selon la revendication 12, dans lequel l'appareil de traitement de substrat comprend en outre un destructeur d'ozone (207) ; le destructeur d'ozone (207) est conçu pour traiter tout excès d'ozone généré par le générateur d'ozone (203) ; le générateur d'ozone (203) a une troisième conduite (214) et une quatrième conduite (215) reliées, et la quatrième conduite (215) est reliée au destructeur d'ozone (207) ; le générateur d'ozone (203) est maintenu dans un état activé, et l'excès d'ozone généré par le générateur d'ozone (203) est traité par le destructeur d'ozone (207).

15. Procédé de traitement de substrat selon la revendication 12, dans lequel le générateur d'ozone (203) est maintenu à l'état activé, lors de la fourniture de gaz aux deuxièmes conduites (206) par l'intermédiaire de la troisième conduite (214), la conduite d'échappement disposée sur la deuxième conduite et à proximité de la source de gaz vecteur (202) évacue le gaz vecteur dans les deuxièmes conduites (206), et un écoulement du gaz évacué est identique à l'écoulement du gaz dans la troisième conduite (214).

16. Procédé de traitement de substrat selon la revendication 14, dans lequel l'appareil de traitement de substrat comprend en outre une pompe à vide (208) et un dispositif de traitement des gaz d'échappement (209), dans lequel la pompe à vide (208) est respectivement reliée à la cavité d'appareil (201) et au dispositif de traitement de gaz d'échappement (209), et le dispositif de traitement de gaz d'échappement (209) est en outre relié au destructeur d'ozone (207) ;
le gaz pompé hors de la cavité d'appareil (201) par la pompe à vide (208) est introduit dans le dispositif de traitement de gaz d'échappement (209) ; et
le gaz évacué à partir du destructeur d'ozone (207) est introduit dans le dispositif de traitement de gaz d'échappement (209).

17. Procédé de traitement de substrat selon la revendication 12, dans lequel le substrat continue à subir le traitement PECVD dans la cavité d'appareil (201) après que le substrat a terminé le traitement ALD thermique dans la cavité d'appareil (201).
